# EUROPEAN PATENT APPLICATION

(11) **EP 1 838 010 A2**
(43) Date of publication of application: **26.09.2007**
(21) Application number: 07104548.8
(22) Date of filing: 21.03.2007
(51) Int. Cl.: H04B 7/005

(54) **Method and apparatus for signal power ramp-up in a data burst transmission**

(30) Priority: 21.03.2006 US 385212
(71) Applicant: M/A-COM, INC., Lowell, MA 01854 (US)
(72) Inventor: Ahmed, Walid Khairy Mohamed, Tinton Falls, NJ 07712 (US)
(74) Representative: Johnstone, Douglas Ian

(57) **Abstract**

A method and apparatus for signal power ramp-up in a communication transmission. Payload data is identified (210, 410) for transmission. A power reference signal is determined (220, 420) for transmission prior to the payload data. The power reference signal and the payload data are combined (230, 430) to form a data burst for transmission. The combined data burst is transmitted (240, 450) as, wherein the power reference signal is transmitted prior to the payload data within the data burst. A feedback signal is provided (250, 460) based on the power reference signal portion of the transmitted data burst, and a pre-distortion signal is calibrated (260, 470) based on the feedback signal.

## Description

The invention relates generally to methods and apparatuses for generating a communication data burst, and more particularly to methods and apparatuses for power ramp-up in a communication data burst transmission.

Electromagnetic waves and signals (hereinafter "signals") are utilized for many different purposes. For example, electromagnetic signals may be processed in order to convey information, such as by attenuating and/or amplifying electromagnetic wave characteristics, for instance, as is seen when modulating the amplitude, frequency or phase of an electrical current or radio frequency (RF) wave to transmit data. As another example, power may be conveyed along a wave in a controlled fashion by attenuating and/or amplifying electromagnetic signals, such as is seen when modulating voltage or current in a circuit. Moreover, the uses may be combined, such as when information may be conveyed through a signal by processing power characteristics.

Electromagnetic signal processing may be accomplished through digital or analog techniques. Digital and analog attenuation and/or amplification also may be combined-that is, the same wave form may be subject to various types of digital and/or analog attenuation and/or amplification within a system in order to accomplish desired tasks.

Frequently, it is important to control the power of signal transmissions. Certain communications systems and networks place constraints on the average and/or peak power that may be transmitted on a channel. For example, power control is important in many communications between base stations and mobile stations, particularly in systems that use multiple-access communication protocols. This includes time-division-multiple-access ("TDMA") systems and code-division-multiple-access ("CDMA") systems, such as those used in many cellular telephone networks. It also includes mobile data network standards such as the general packet radio service ("GPRS") standard and the enhanced data rates for GSM evolution ("EDGE") standard.

In addition, some communication systems use filters and/or correction tables to compensate for undesired effects on an input signal caused by modulation, amplification, or other processing during the transmission process. For instance, the frequency responses of a power amplifier may include certain non-linearities. Some digital communication systems correct for such undesired effects by pre-distorting the input signal before amplification to ensure the correct output signal based on the known frequency response of the amplifier. For example, pre-distortion lookup tables may be used for this purpose. The lookup tables include correction values that may be used to compensate for non-linearities and to provide the desired output magnitude or phase component for a given input value.

To ensure that pre-distortion systems of the type described above provide the correct output, it is important to know the frequency response of the power amplifier and/or transmitter. For this reason, it sometimes is necessary to calibrate the pre-distortion system to match the actual output frequency response. Such calibration may be performed during a startup operation before any communication data is transmitted. However, the actual output frequency response may change over time due to variations in temperature, operational frequency, load characteristics, etc. As a result, it would be helpful to provide a method and/or apparatus for periodically calibrating an amplifier or transmitter pre-distortion system during normal communication operation.

Accordingly, there is a need for methods and apparatuses for improving power control in communication signals. There is also a need for methods and apparatuses that enable proper and periodic calibration of correction tables with respect to an input signal for communication transmission.

The solution is provided by a method of generating a communication data burst. A plurality of payload data is identified for transmission. A power reference signal is determined for transmission prior to the payload data. The power reference signal and the payload data are combined to form a data burst. The data burst is transmitted with the power reference signal being transmitted prior to the payload data within the data burst. A feedback signal is provided based on the power reference signal portion of the transmitted data burst, and a pre-distortion signal is calibrated based on the feedback signal.

The solution is also provided by a method of generating an augmented EDGE data burst for radio-frequency transmission on an EDGE channel between a wireless communication device and a network. A plurality of payload data, including a plurality of 8PSK modulated symbols, is identified for transmission. A power reference signal is determined for transmission prior to the payload data. The power reference signal and the payload data are combined to form an augmented EDGE data burst. The augmented EDGE data burst is transmitted as a radio-frequency transmission, with the power reference signal being transmitted prior to the payload data within the augmented data burst. A feedback signal is provided based on the power reference signal portion of the transmitted augmented EDGE data burst, and a pre-distortion signal is calibrated based on the feedback signal.

The solution is also provided by an apparatus for generating a communication data burst. The apparatus includes a signal processor programmed with instructions and configured to receive a plurality of payload data to be transmitted. The signal processor determines a power reference signal to be transmitted prior to the payload data, and combines at least the power reference signal and the payload data to form the data burst. The apparatus also includes an amplifier in communication with the signal processor and configured to amplify the data burst. The apparatus includes an antenna in communication with the amplifier and configured to transmit the amplified data burst. The power reference signal is transmitted prior to the payload data within the amplified data burst. The apparatus also includes a feedback loop in communication with the amplifier and the signal processor and is configured to provide a feedback signal based on the power reference signal portion of the amplified data burst. The apparatus includes a pre-distortion filter configured to pre-distort a subsequent data burst prior to transmission. The pre-distortion filter is configured for calibration based on the feedback signal.

The components in the figures are not necessarily to scale, emphasis instead being placed upon illustrating the principles of the invention. Moreover, in the figures, like referenced numerals designate corresponding parts throughout the different views. The invention will now be described by way of example with reference to the accompanying drawings in which:

Figure 1 is a block diagram illustrating a transmitter according to one aspect of the invention;

Figure 2 is a flow diagram illustrating a method, according to another aspect of the invention, of generating a communication data burst;

Figure 3 is a block diagram illustrating a transmitter for use in an EDGE network according to one aspect of the invention;

Figure 4 is a flow diagram illustrating a method, according to another aspect of the invention, of generating an augmented EDGE data burst for radio-frequency transmission on an EDGE channel between a wireless communication device and a network;

Figure 5 is a timing diagram illustrating an augmented EDGE data burst according to another aspect of the invention; and

Figure 6 is a timing diagram illustrating an augmented EDGE data burst according to another aspect of the invention.

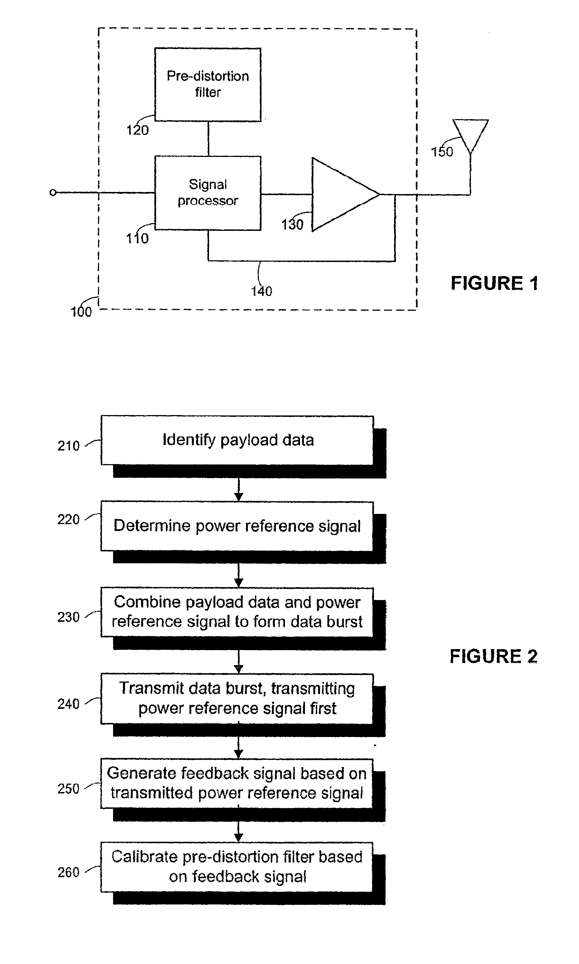

Embodiments of the invention include apparatuses, methods and articles of manufacture for processing electromagnetic waves and signals. For illustration purposes, an exemplary embodiment comprises a signal processor configured to determine a power reference signal. The signal processor and the power reference signals described in this application may be implemented in a wide range of applications, such as, for example, a baseband processor, a phase, frequency, or amplitude modulator, an amplifier, a transmitter, etc. For purposes of illustration, an exemplary transmitter is illustrated in Figure 1.

One example of a transmitter according to one aspect of the invention is illustrated in Figure 1. The transmitter 100 includes a signal processor 110, a pre-distortion filter 120, an amplifier 130, and a feedback loop 140. The transmitter 100 is also configured with an antenna 150. The various components of the exemplary transmitter 100, which are described in more detail below, may be analog or digital in nature. The exemplary transmitter 100 also may include a combination of analog and digital components, and may include other components, such as a baseband processor, modulator, etc., depending on the particular application. In addition, various of the transmitter components may be combined into a single component according to the design parameters of a particular application.

The term "signal," as is used herein, should be broadly construed to include any manner of conveying data from one place to another, such as, for example, an electric current or electromagnetic field, including without limitation, a direct current that is switched on and off or an alternating-current or electromagnetic carrier that contains one or more data streams. Data, for example, may be superimposed on a carrier current or wave by means of modulation, which may be accomplished in analog or digital form. The term "data" as used herein should also be broadly construed to comprise any type of intelligence or other information, such as, for example and without limitation, audio, video, and/or text information.

As illustrated in Figure 1, the signal processor 110 may be, for example, a digital signal processor. The processed output signal generated by the signal processor 110 in this embodiment may comprise a digital signal or an electromagnetic wave that contains data derived from the input signal. The signal processor 110 may include an analog to digital converter and produce a digital output signal.

The signal processor 110 is configured to receive or otherwise determine payload data that is to be transmitted, for example, between a wireless communication device and a network (not illustrated). For example, the signal processor 110 may be a digital signal processor programmed with instructions receive a plurality of payload data for transmission. The signal processor 110 is further configured to determine a power reference signal to be transmitted prior to the payload data and to combine the power reference signal and the payload data to form a data burst. Again, by way of example, the signal processor 110 may be a digital signal processor programmed with instructions to determine the power reference signal and to combine the power reference signal with the payload data to form the data burst. The signal processor 110 also may include additional data in the data burst, depending on the particular application.

In the transmitter illustrated in Figure 1, the signal processor 110 is in communication with optional pre-distortion filter 120. The pre-distortion filter 120 compensates for non-linearities in the amplifier 130 or elsewhere in the transmitter 100 by pre-distorting the communication signal before amplification and transmission. The pre-distortion is based on the known frequency response of the amplifier 130 and/or the transmitter 100. For example, the pre-distortion filter may use lookup tables to provide a correction value for a given magnitude or phase of the input signal.

Although Figure 1 illustrates the pre-distortion filter 120 as a separate component from the signal processor 110, it also is possible to combine these components in a single device. For example, the pre-distortion filter may be implemented using logic instructions and lookup tables within the signal processor 110 itself.

The signal processor 110 also is in communication with the amplifier 130. The amplifier 130 receives and amplifies the data burst as necessary depending on the application. The transmitter 100 also may include a modulator (not shown) for modulating the data burst according to the appropriate modulation protocol for the particular communication network. Optionally, the amplifier 130 may provide the amplified signal to an antenna 150 for radio-frequency transmission.

As illustrated in Figure 1, the transmitter 100 also includes optional feedback loop 140, which provides feedback to the signal processor 110 based on the output from the amplifier 130. Information from feedback loop 140 may be used, for example, to calibrate the pre-distortion filter 120 in accordance with the current frequency response of the amplifier 130 and/or the transmitter 100.

The power reference signal determined by the signal processor 110 may provide various advantages. One advantage is that the power reference signal may be selected or calculated to ensure that the overall data burst (including both the power reference signal and the payload data, as well as any other desired data) meets desired power criteria. For example, the power reference signal may be selected or calculated to ensure a desired peak or average power value in the transmitted data burst. The power reference signal also may be chosen to ensure that the data burst meets desired criteria for switching transients.

Another advantage is that the power reference signal may be selected to provide a calibration signal for the pre-distortion filter 120. For example, the power reference signal may be selected to span all possible output values, from zero to the maximum, during the ramp-up of the data burst. This enables the pre-distortion filter 120, which receives feedback via feedback loop 140 and signal processor 110, to implement complete correction tables for the actual frequency response of the amplifier 130 and/or the transmitter 100.

When the power reference signal portion of the data burst is transmitted, the feedback loop 140 provides a feedback signal based on the actual transmitted power reference signal. In the transmitter 100 illustrated in Figure 1, this feedback signal is received by the signal processor 110. The feedback signal may be used to calibrate the pre-distortion filter 120. For example, the signal processor 110 may pass the raw feedback signal to the pre-distortion filter for use in calibration. Alternatively, the signal processor 110 may process the feedback signal to determine the proper calibration and then provide a calibration signal to control calibration of the pre-distortion filter 120.

Because the calibration process is based on the transmission of a power reference signal at the beginning of a communication data burst, the calibration process may be performed during normal communication operation. The calibration need not be limited to a dedicated communication sent solely for purposes of calibration, for example, during a start-up routine. Rather, the pre-distortion filter 120 may be calibrated on a regular, periodic basis during normal communication operation of the transmitter 100. If desired, the calibration process may be performed during transmission of every data burst.

Turning now to Figure 2, the flow diagram illustrates a method of generating a communication data burst. The method illustrated in Figure 2 may be implemented using a transmitter such as the transmitter 100 illustrated in Figure 1. A plurality of payload data to be transmitted on is identified 210. The payload data may be identified in various ways. For example, the payload data may be received from a source for transmission, or it may be generated by the transmitter itself. The payload data may take various forms. For example, the payload data may be a series of modulated symbols, such as Gaussian minimum-shift keying ("GMSK") symbols or 8-phase shift keying ("8PSK") symbols.

A power reference signal is determined at 220. The power reference signal may be selected or calculated to meet desired calibration or power criteria, depending on the particular modulation protocol and communication network. The power reference signal may take various forms, including a series of digital signal samples or a series of modulated symbols, such as GMSK or 8PSK symbols.

The payload data and the power reference signal are combined 230 to form a data burst. The data burst also may include other desired signals or information. The data burst is transmitted 240, with the power reference signal being transmitted prior to the payload data. Before transmission, the data burst may be modulated in any desired manner. For example, if the power reference signal and the payload data include modulated symbols, those symbols may be modulated onto a radio-frequency carrier wave.

A feedback signal is generated 250 based on the transmission 240 of the data burst. Part of the feedback signal reflects the actual transmitted power reference signal. Because the feedback signal is based on the actual transmitted signal (e.g., the output of the amplifier 130), it reflects any non-linearities in the current frequency response of the amplifier and/or transmitter (e.g., amplifier 130 and/or transmitter 100) at the time the power reference signal is transmitted. This information from the feedback signal is used to calibrate 260 a pre-distortion signal, such as the signal provided by the pre-distortion filter 120 shown in Figure 1. As a result, the pre-distortion filter 120 may be calibrated on a regular, periodic basis during normal communication operation of the transmitter 100. As noted above, this calibration process may be performed during transmission of every data burst if desired.

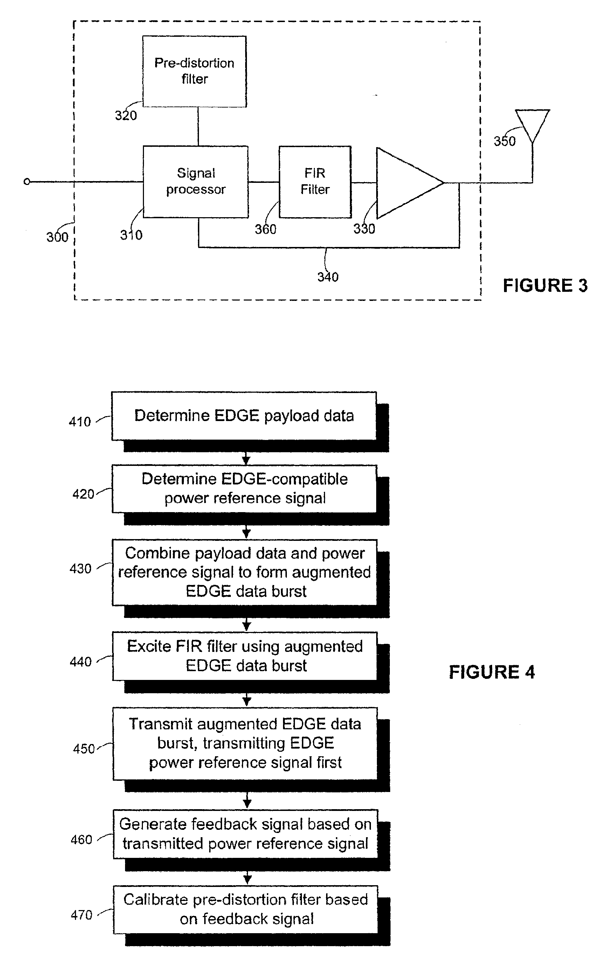

An example of an EDGE transmitter according to another aspect of the invention is illustrated in Figure 3. The EDGE transmitter is designed for use in a network based on the EDGE data communication standard. The EDGE transmitter 300 includes a signal processor 310, a finite impulse response ("FIR") filter 360, an amplifier 330, and a feedback loop 340. The EDGE transmitter 300 also is configured with an antenna 350. Like the transmitter 100 illustrated in Figure 1, the various components of the exemplary EDGE transmitter 300, which are described in more detail below, may be analog or digital in nature. The EDGE transmitter 300 also may include a combination of analog and digital components, and may include other components, such as a baseband processor, modulator, etc., depending on the particular application. In addition, various of the transmitter components may be combined into a single component according to the design parameters of a particular application.

As illustrated in Figure 3, the signal processor 310 may be, for example, a digital signal processor. The processed output signal generated by the signal processor 310 in this embodiment may comprise a digital signal or an electromagnetic wave that contains data derived from the input signal. The signal processor 310 may include an analog to digital converter and produce a digital output signal.

The signal processor 310 is configured to receive or otherwise determine payload data that is to be transmitted between a wireless communication device and a network. For example, the signal processor 310 may be a digital signal processor programmed with instructions to receive a plurality of payload data for transmission.

Like the signal processor 110 illustrated in Figure 1, the signal processor 310 is further configured to determine a power reference signal to be transmitted prior to the payload data and to combine the power reference signal and the payload data to form an augmented EDGE data burst. Again, by way of example, the signal processor 310 may be a digital signal processor programmed with instructions to determine the power reference signal and to combine the power reference signal with the payload data to form the augmented EDGE data burst. The signal processor 310 also may include additional data in the augmented EDGE data burst, depending on the particular application.

The signal processor 310 is also in communication with optional pre-distortion filter 320. Like the pre-distortion filter 120 discussed above with respect to Figure 1, the pre-distortion filter 320 compensates for non-linearities in the amplifier 330 or elsewhere in the transmitter 300 (e.g., in FIR filter 360) by pre-distorting the communication signal before FIR filtering, amplification, and/or transmission. The pre-distortion is based on the known frequency response of the amplifier 330 and/or other components of the transmitter 100. For example, the pre-distortion filter may use lookup tables to provide a correction value for a given magnitude or phase of the input signal.

Although Figure 3 illustrates the pre-distortion filter 320 as a separate component from the signal processor 310, it also is possible to combine these components in a single device. For example, the pre-distortion filter may be implemented using logic instructions and lookup tables within the signal processor 310 itself.

In the EDGE transmitter illustrated in Figure 3, the signal processor 310 is in communication with a FIR filter 360. The 8PSK symbols of the augmented EDGE data burst excite the FIR filter 360 to produce a radio-frequency version of the augmented EDGE data burst for transmission.

The amplifier 330 receives and amplifies the radio-frequency data burst as necessary depending on the application. Optionally, the amplifier 330 may provide the amplified augmented EDGE data burst signal to an antenna 350 for radio-frequency transmission.

As illustrated in Figure 3, the transmitter 300 also includes optional feedback loop 340, which provides feedback to the signal processor 310 based on the output from the amplifier 330. As explained above with respect to the transmitter 100 illustrated in Figure 1, information from feedback loop 340 may be used, for example, to calibrate the pre-distortion filter 320 in accordance with the current frequency response of the FIR filter 360, the amplifier 330, and/or other components of the transmitter 100.

As noted above, the power reference signal determined by the signal processor 310 may provide various advantages. One advantage is that the power reference signal may be selected or calculated to ensure that the augmented EDGE data burst (including both the power reference signal and the payload data, as well as any other desired data) meets desired power criteria. For example, the power reference signal may be selected or calculated to ensure that the augmented EDGE data burst meets the power and switching transient constraints of the EDGE standard. For example, such constraints include those set forth in 3GPP TS 11.10: "Digital cellular telecommunications system (Phase 2+); Mobile State (MS) Conformance Specification" and 3GPP 11.11: "Digital cellular telecommunications system (Phase 2+); Specification of the Subscriber Identify Module - Mobile Equipment (SIM - ME) Interface." The power reference signal may also be chosen to ensure that the augmented EDGE data burst satisfies the limitations on switching transient imposed by the EDGE standard.

Another advantage is that the power reference signal may be selected to provide a calibration signal for the EDGE transmitter 300. For example, the power reference signal may be selected to span all possible output values, from zero to the maximum, during the ramp-up of the augmented EDGE data burst. This enables the pre-distortion filter 320, which receives feedback via feedback loop 340 and signal processor 310, to implement complete correction tables for the actual frequency response of the FIR filter 360, the amplifier 330, and/or other components of the transmitter 300.

Turning now to Figure 4, the flow diagram illustrates a method of generating an augmented EDGE data burst for radio-frequency transmission between a wireless communication device and a network. The method illustrated in Figure 4 may be implemented using a transmitter such as the EDGE transmitter 300 illustrated in Figure 3. A plurality of payload data to be transmitted is identified at 410. The payload data may be identified in various ways. For example, the payload data may be received from a source for transmission, or it may be generated by the transmitter itself. In the case of the EDGE transmitter 300, the payload data typically would take the form of 8PSK symbols in accordance with the EDGE standard.

A power reference signal is determined at 420. The power reference signal may be selected or calculated to meet desired calibration or power criteria, depending on the particular modulation protocol and communication network. The power reference signal may take various forms, including a series of digital signal samples or a series of 8PSK symbols. Regardless of whether the power reference signal is a series of digital signal samples or 8PSK symbols, it may be selected to produce a radio-frequency signal that meets the desired criteria, as discussed above, after being masked by the FIR filter.

The payload data and the power reference signal are combined 430 to form an augmented EDGE data burst. The augmented EDGE data burst also may include other desired signals or information. The augmented EDGE data burst is filtered 440 using an FIR filter to produce a radio-frequency version of the augmented EDGE data burst. For example, the modulated symbols and/or digital signal samples of the augmented EDGE data burst may be used to excite the FIR filter to produce a radio-frequency version of the augmented EDGE data burst for transmission. The augmented EDGE data burst is transmitted 450 in radio-frequency form, with the power reference signal being transmitted prior to the payload data.

A feedback signal is generated 460 based on the transmission 450 of the augmented EDGE data burst. Like the feedback signals discussed above, part of the feedback signal reflects the actual transmitted power reference signal. Because the feedback signal is based on the actual transmitted signal (e.g., the output of the amplifier 330), it reflects any non-linearities in the current frequency response of the amplifier and/or other transmitter components (e.g., FIR filter 360, amplifier 330, and/or transmitter 300) at the time the power reference signal is transmitted. This information from the feedback signal is used to calibrate 470 a pre-distortion signal, such as the signal provided by the pre-distortion filter 320 shown in Figure 3. As a result, the pre-distortion filter 320 may be calibrated on a regular, periodic basis during normal communication operation of the EDGE transmitter 300. Like the calibration processes described above, this calibration process may be performed during transmission of every data burst if desired.

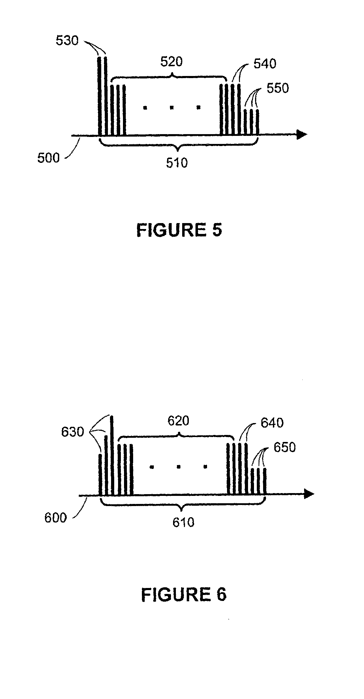

Figure 5 is a timing diagram illustrating an augmented EDGE data burst 510 according to another aspect of the invention. In Figure 5, the typical 8PSK symbols of the EDGE standard are illustrated as impulses on the timeline 500. The payload data symbols 520 are shown in the middle of the augmented EDGE data burst 510. A normal duration EDGE data burst typically includes 147 8PSK payload data symbols 520. (For convenience, only a small number of the payload data symbols are illustrated in Figure 5.)

In the augmented EDGE data burst 510 illustrated in Figure 5, the power reference signal 530 is shown as two 8PSK symbols preceding the payload data symbols 520. These two symbols 530 provide a desired "overshoot" before the payload data symbols, which enables calibration of the pre-distortion filter (e.g., pre-distortion filter 320), as discussed above. Although it is not required, at least one symbol of the power reference signal is preferably of the maximum magnitude permitted by the system. This helps to ensure proper calibration.

As illustrated, the two symbols 530 of the power reference signal are of equal magnitude, although the symbols also could have varying magnitudes, consistent with the switching transient constraints of the EDGE standard. Although the power reference signal is shown to include only two 8PSK symbols, it may include more or less symbols consistent with the data burst time mask imposed by the EDGE standard.

As an example, the two 8PSK symbols 530 of the power reference signal may be two symbols of the form *s*₁ = *a*₁ + *jb*₁*.* The coefficients *a*₁ and *b*₁ may be selected for each symbol according to the desired power reference signal for a given application. The symbols may be, but need not be, rotated in the manner that payload data symbols are rotated according to the EDGE standard. In addition, as in the alternative noted above, the power reference signal may constitute a series of digital signal samples selected to produce a radio-frequency signal that meets the desired criteria after being masked by the FIR filter.

The augmented EDGE data burst 510 illustrated in Figure 5 also includes two ramp-down symbols 540 and three termination symbols 550. If desired or needed, these symbols may be included in the augmented EDGE data burst to satisfy requirements such as the average power or switching transient constraints of the EDGE standard.

Figure 6 is a timing diagram illustrating another augmented EDGE data burst 610 according to another aspect of the invention. The augmented data burst 610 shown in Figure 6 includes a power reference signal consisting of three 8PSK symbols 630 of increasing magnitude. Again, these three symbols 630 provide a desired "overshoot" before the payload data symbols, which enables calibration of the pre-distortion filter (e.g., pre-distortion filter 320), as discussed above. Although it is not required, at least one symbol of the power reference signal is preferably of the maximum magnitude permitted by the system, which helps to ensure proper calibration.

As illustrated, the three symbols 630 of the power reference signal are of increasing magnitude, although the symbols could also have equal, decreasing, or otherwise varying magnitudes, consistent with the switching transient constraints of the EDGE standard. In addition, although the power reference signal is shown to include three 8PSK symbols, it may include more or less symbols consistent with the data burst time mask imposed by the EDGE standard.

Like the symbols 530 of the power reference signal illustrated in Figure 5, the two 8PSK symbols 530 of the power reference signal may be two symbols of the form *s*₁ = *a*₁ + *jb*₁*,* with coefficients *a*₁ and *b*₁ selected for each symbol according to the desired power reference signal for a given application. In addition, the symbols may be, but need not be, rotated in the manner that payload data symbols are rotated according to the EDGE standard. Also, as in the alternative noted above, the power reference signal may constitute a series of digital signal samples selected to produce a radio-frequency signal that meets the desired criteria after being masked by the FIR filter.

The other aspects of the augmented EDGE data burst 610, including the timeline 600, the payload data burst symbols 620, the ramp-down symbols 640, and the termination symbols 650, are similar to those discussed above with respect to Figure 5.

Certain transmitters, receivers, transceivers, and other components such as the signal processors 110 and 310 may be specialized for particular input signals, carrier waves, and output signals (e.g., various types of cell phones, such as CDMA, CDMA2000, WCDMA, GSM, TDMA), as well as various other types of devices, both wired and wireless (e.g., Bluetooth, 802.11 a, -b, -g, radar, IxRTT, radios, GPRS, EDGE, computers, computer or non-computer communication devices, or handheld devices). The modulation schemes used in these environments may include, for example, GMSK, which is used in GSM; GFSK, which is used in DECT & Bluetooth; 8-PSK, which is used in EDGE; OQPSK & HPSK, which are used in IS-2000; p/4 DQPSK, which is used in TDMA; and OFDM, which is used in 802.11.

## Claims

1. A method of generating a communication data burst, comprising:
identifying a plurality of payload data (210) to be transmitted;
determining a power reference signal (220) to be transmitted prior to the payload data;
combining at least the power reference signal and the payload data to form a data burst (230);
transmitting the data burst (240) as a radio-frequency transmission, wherein the power reference signal is transmitted prior to the payload data within the data burst;
providing a feedback signal (250) based on the power reference signal portion of the transmitted data burst; and
calibrating a pre-distortion signal (260) based on the feedback signal.

2. The method of claim 1, wherein the calibration (260) is performed for each data burst transmitted.

3. The method of claim 1 or 2, wherein the power reference signal comprises one or more digital signal samples.

4. The method of claim 1 or 2, wherein the power reference signal comprises one or more modulated symbols.

5. The method of claim 4, wherein the modulated symbols of the power reference signal comprise two or more sequential symbols of equal magnitude.

6. The method of claim 4, wherein the modulated symbols of the power reference signal comprise two or more sequential symbols of increasing magnitude.

7. The method of claim 4, wherein the modulated symbols of the power reference signal are unrotated.

8. A method of generating an augmented EDGE data burst for radio-frequency transmission on an EDGE channel between a wireless communication device and a network, comprising:
identifying a plurality payload data (410), including a plurality of 8PSK-modulated symbols, to be transmitted;
determining a power reference signal (420) to be transmitted prior to the payload data;
combining at least the power reference signal and the payload data (430) to form the augmented EDGE data burst;
transmitting the augmented EDGE data burst (450) as a radio-frequency transmission, wherein the power reference signal is transmitted prior to the payload data within the data burst;
providing a feedback signal (460) based on the power reference signal portion of the transmitted augmented EDGE data burst; and
calibrating a pre-distortion signal (470) based on the feedback signal.

9. The method of claim 8, wherein the calibration (470) is performed for each augmented EDGE data burst transmitted.

10. The method of claim 8 or 9, wherein the power reference signal comprises one or more digital signal samples.

11. The method of claim 8 or 9, wherein the power reference signal comprises one or more 8PSK-modulated symbols.

12. The method of claim 11, wherein the modulated symbols of the power reference signal are unrotated.

13. An apparatus for generating a communication data burst, comprising:
a signal processor (110, 310) programmed with instructions and configured to receive a plurality of payload data to be transmitted, to determine a power reference signal to be transmitted prior to the payload data, and to combine at least the power reference signal and the payload data to form the data burst;
an amplifier (130, 330) in communication with the signal processor (110, 310) and configured to amplify the data burst;
an antenna (150, 350) in communication with the amplifier (130, 330) and configured to transmit the amplified data burst, wherein the power reference signal is transmitted prior to the payload data within the amplified data burst
a feedback loop (140, 340) in communication with the amplifier (130, 330) and the signal processor (110, 310) and configured to provide a feedback signal based on the power reference signal portion of the amplified data burst; and
a pre-distortion filter (120, 320) configured to pre-distort a subsequent data burst prior to transmission, wherein the pre-distortion filter is configured for calibration based on the feedback signal.

14. The apparatus of claim 13, wherein the power reference signal comprises one or more digital signal samples.

15. The apparatus of claim 13, wherein the power reference signal comprises one or more modulated symbols.

16. The apparatus of claim 15, wherein the modulated symbols of the power reference signal comprise two or more sequential symbols of equal magnitude.

17. The apparatus of claim 15, wherein the modulated symbols of the power reference signal comprise two or more sequential symbols of increasing magnitude.

18. The apparatus of claim 15, wherein the modulated symbols of the power reference signal are unrotated.

19. The apparatus of any claim 13 to 18, further comprising:
an FIR filter (360) in communication with the signal processor (310) and the transmitter;
wherein the FIR filter (360) is configured to filter the modulated symbols of the power reference signal and the payload data prior to transmission of the data burst.
